# EUROPÄISCHE PATENTSCHRIFT

(11) **EP 1 381 874 B1**
(45) Veröffentlichungstag und Bekanntmachung des Hinweises auf die Patenterteilung: **19.11.2008**
(21) Anmeldenummer: 02730193.6
(22) Anmeldetag: 23.04.2002
(51) Int. Cl.: G01R 29/10, G01R 31/28

(54) **VERFAHREN UND VORRICHTUNG ZUM KONTAKTLOSEN TESTEN UNBESTÜCKTER ANTENNEN**
METHOD AND DEVICE FOR CONTACLESS TESTING OF NON-FITTED ANTENNAE
PROCEDE ET DISPOSITIF POUR TESTER SANS CONTACT UNE ANTENNE NON EQUIPEE

(30) Priorität: 26.04.2001 DE 10120625
(43) Veröffentlichungstag der Anmeldung: 21.01.2004
(73) Patentinhaber: Mühlbauer AG, 93426 Roding (DE)
(72) Erfinder: BROD, Volker, 93077 Bad Abbach (DE)
(74) Vertreter: Grünecker, Kinkeldey, Stockmair & Schwanhäusser Anwaltssozietät
(86) Internationale Anmeldenummer: PCT/EP2002/004462
(87) Internationale Veröffentlichungsnummer: WO 2002/088762

(56) Entgegenhaltungen:
- EP-A- 0 142 380
- WO-A-98/40766
- DE-C- 19 735 282
- JP-A- 7 248 347
- US-A- 6 008 993
- US-A- 6 104 291

## Beschreibung

Die Erfindung betrifft ein Verfahren zum kontaktlosen Testen der elektromagnetischen Eigenschaften einer Antenne mit einem Messgerät gemäß dem Oberbegriff des Anspruchs 1, sowie ein Messgerät gemäß dem Oberbegriff des Anspruchs 7.

Kontaktlose Identifikationssysteme sind in der Überwachung und Steuerung von Güter- oder Warenflüssen weit verbreitet. Neben Barcode-Systemen setzen sich immer mehr Transponder-gestützte Systeme durch. Der Transponder besteht dabei üblicherweise aus einem Koppelelement in Form einer Antenne oder Spule, sowie einem elektronischen Mikrochip. Die zum Betrieb des Transponders benötigte Energie wird ebenso wie Takt und Daten kontaktlos zur Antenne des Transponders übertragen.

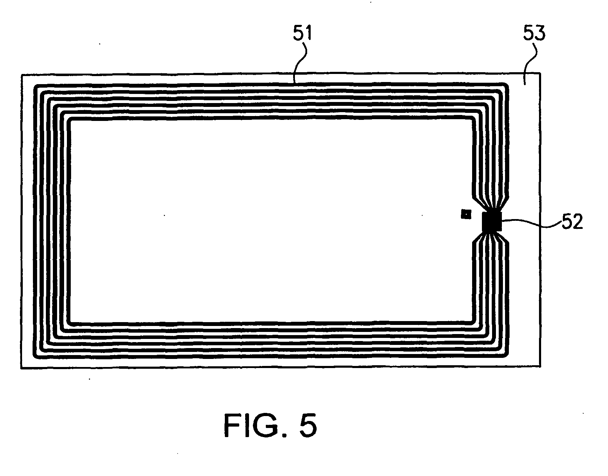

Fig. 5 zeigt einen Transponder mit einer Antenne 51, einen mit der Antenne verbundenen Chip 52, und eine dünne Folie 53, auf welcher der Transponder angeordnet ist. Die Antenne wird in diesem Beispiel durch 6 auf die Folie aufgebrachte Leiterbahnen gebildet. Derartige flexible Antennen auf Folien sind in ihrer Produktion besonders fehleranfällig und müssen, wie in WO 98/40766 vorgeschlagen, entsprechend vor einer Bestückung mit dem Chip getestet werden.

Für den Test einer, noch nicht mit dem Chip zu einem Transponder verbundenen, Antenne muss die Antenne üblicherweise kontaktiert werden. Ein solches Testsystem für Antennen beschreibt beispielsweise die Druckschrift US 4,884,078. Auch gemäß der Veröffentlichung JP 05157782 A wird eine Antenne zur Messung ihrer elektromagnetischen Eigenschaften zunächst mit einem Messgerät verbunden.

Die Druckschrift US 6,104,291 beschreibt ein Verfahren zum kontaktlosen Testen von Transpondem für Radiofrequenz-Identifikations-(RFID)-Systemen. Die Transponder werden dabei einzeln im vollständig bestückten Zustand auf ihre Funktionalität getestet, um defekte Transponder auszusortieren. Dieses Verfahren besitzt jedoch den Nachteil, dass bei einer defekten Antenne auch die teuren funktionsfähigen Chips, die mit defekten Antennen verbunden sind, aussortiert werden, wodurch unnötigerweise Ressourcen vernichtet werden.

Die US Patenschrift 6,104,291 offenbart ein Verfahren zum kontaktlosen Testen der elektromagnetischen Eigenschaften einer Antenne mittels eines Messgeräts, wobei die Antenne geeignet ist, in einem mit einem Chip bestückten Zustand einen Transponder für ein Identifikationssystem zu bilden. Dabei umfasst das aus dieser Druckschrift bekannte Verfahren die folgenden Schritte: Senden eines elektromagnetischen Messfeldes vor gegebener Frequenz durch eine Sendeantenne des Messgeräts; Testen der in dem Messfeld angeordneten Antenne bei der vorgegebenen Frequenz und Auswerten des Testergebnisses durch Vergleich mit einem Referenzwert. Dabei ist die Antenne für die Durchführung dieser Tests mit einem Chip bestückt und es wird die Antwort des vollständig montierten Transponders auf das elektromagnetische Messfeld ermittelt.

Aus der Druckschrift WO 98/40766 A ist ein Verfahren zum Testen der elektromagnetischen Eigenschaften einer Transponderantenne bekannt, bei dem die Testschritte zum Testen der durch eine Spule gebildeten Antenne durchgeführt werden, indem die Spule mit einem integrierten Schaltkreis kontaktiert wird. Eine kontaktlose Messung ist hier nicht gezeigt.

Die JP 07248347 A bezieht sich auf ein Messverfahren zum Testen eines Tags, wobei das Tag aus einer Spule und einem Kondensator besteht. Die Messanordnung umfasst eine Sendevorrichtung, die aus einer Spule und einem Sinuswellengenerator besteht, und einem Detektor, der eine Detektorspule und ein Wechselspannungsmessgerät enthält. Durch die Kopplung der drei Schwingkreise miteinander kann eine Frequenzcharakteristik des Tags bei bekannter Anregung durch den Sendekreis mit Hilfe des Detektorkreises gemessen werden.

Es ist die Aufgabe der vorliegenden Erfindung, ein Verfahren und eine Vorrichtung zum Testen von Antennen bereitzustellen, welche mit hoher Zuverlässigkeit möglichst effizient fehlerhafte Antennen aussortieren.

Diese Aufgabe wird durch ein Verfahren gemäss den Merkmalen des Anspruchs 1, sowie durch ein System mit den Merkmalen des Anspruchs 5 gelöst. Die Unterensprüche beschreiben bevorzugte Ausführungsformen der Erfindung.

Ein Verfahren zum kontaktlosen Testen der elektromagnetischen Eigenschaften einer Antenne mit einem Messgerät, wobei die Antenne geeignet ist, im bestückten Zustand mit einem Chip einen Transponder für ein Identifikationssystem zu bilden, erfolgt mit folgenden Schritten: Senden eines elektromagnetischen Messfeldes vorgegebener Frequenz durch eine Sendeantenne des Messgerätes, Testen der In dem Messfeld angeordneten Antenne bei der vorgegebenen Frequenz, Auswerten des Testergebnisses der Antenne durch Vergleich mit einem Referenzwert, wobei die Verfahrensschritte im unbestückten Zustand der Antenne durchgeführt werden.

Der vorliegenden Erfindung liegt die Erkenntnis zugrunde, dass es von erheblichem Vorteil ist, wenn bereits in einem sehr frühen Schritt des Herstellungsvorgengs einer Transponderantenne diese auf Ihre Funktionsfähigkeit überprüft wird. Da diejenigen Verfahren, bei denen die Antenne zuvor kontaktiert werden muss, aufgrund ihrer Prozessunsicherheit für die Herstellung von hohen Produktionszahlen ausscheiden, ist es ein erheblicher Vorteil, wenn das Testverfahren kontaktlos durchgeführt werden kann. Weiterhin vermeidet das erfindungsgemäße Verfahren den Nachteil im Stand der Technik, dass bei einer Überprüfung des vollständig bestückten Transponders elektronische Bauelemente, die für sich genommen funktionsfähig sind, aussortiert werden. Erfindungsgemäß wurde erkannt, dass besonders die Herstellung flexibler Antennen fehleranfällig Ist und daher zu einem sehr frühen Zeitpunkt des Produktionsvorgangs getestet werden sollte.

Gemäß einer bevorzugten Ausgestaltung des Verfahrens, wird beim Senden die Frequenz des Messfeldes in einem vorbestimmten Frequenzbereich variiert. Somit kann einerseits der Einfluss der Antenne auf das Messfeld leichter gemessen werden, andererseits die Qualität der gemessenen Antenne genauer bewertet werden.

Besonders zweckmäßig ist es, in dem Verfahren einen Normbereich für einen maximalen Einfluss der unbestückten Antenne auf das Messfeld als Referenzwert zu verwenden. Dadurch können Messtoleranzen, sowie akzeptable Abweichungen der Antennenqualität berücksichtigt werden.

Ein Messgerät zum Testen der elektromagnetischen Eigenschaften einer solchen Antenne umfasst eine Spannungsquelle zur Erzeugung einer Wechselspannung vorgegebener Frequenz, eine Sendeantenne, die ein elektrisches Messfeld mit der vorgegebenen Frequenz senden kann, eine Messeinheit, die für die Antenne bei der vorgegebenen Frequenz einen Wert misst, eine Auswertungseinheit, die so ausgebildet ist, dass sie einen in der Messeinheit gemessenen Wert mit einem Referenzwert für eine Norm-Antenne vergleicht. Erfindungsgemäß sind die Spannungsquelle, die Sendeantenne, die Mess- sowie Auswertungseinheit so empfindlich ausgelegt, dass sie die Antenne im unbestückten Zustand messen. Somit können Antennen im unbestückten Zustand auf ihre elektromagnetischen Eigenschaften getestet werden, ohne sie kontaktieren zu müssen.

Gemäss einer bevorzugten Ausgestaltung des Messgerätes umfasst das Messgerät weiterhin eine Steuereinheit zur Steuerung zumindest der Auswertungseinheit und der Spannungsquelle. Durch die Steuereinheit kann der vorgegebene Frequenzbereich automatisch durchgestimmt (gewobbelt) werden.

Durch geeignete Abschirmungsmaßnahmen wird ein Einfluss weiterer Antennen auf das Messfeld verhindert. Somit wird eine Messung einer Vielzahl von dicht nebeneinander angeordneten Antennen ermöglicht.

Im folgenden werden bevorzugte Ausführungsformen der Erfindung anhand der Zeichnungen beschrieben, welche im einzelnen zeigen:
- Fig. 1: eine schematische Darstellung eines Messgerätes und einer nicht bestückten Antenne,
- Fig. 2: eine schematische Darstellung eines Messgerätes zum Testen einer Vielzahl von nicht bestückten Antennen,
- Fig. 3: eine graphische Darstellung eines frequenzabhängig gemessenen Einflusses einer Antenne auf das Messfeld,
- Fig. 4: eine schematische Darstellung der Einheiten in dem Messgerät aus Fig. 1 oder 2,
- Fig. 5: eine Darstellung eines Transponders mit Antenne und Chip.

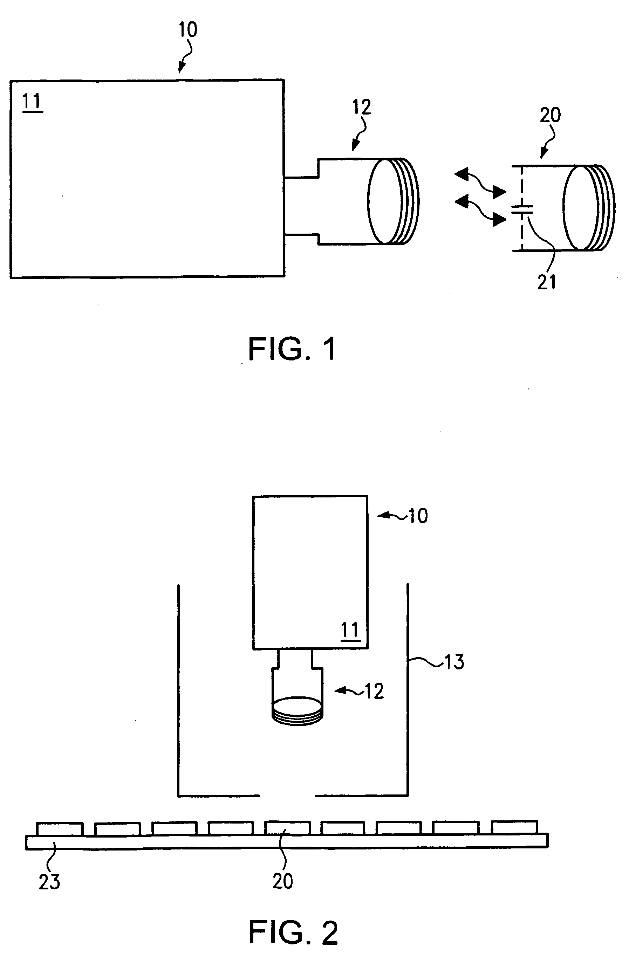

Fig. 1 zeigt ein Messgerät 10 mit einer Sendeantenne 12 und einer Zentraleinheit 11, sowie eine zu messende nicht kontaktierte Antenne im unbestückten Zustand. Für die Antenne 20 ist mit gestrichelten Linien eine Kapazität 21 angedeutet, die eine immanente Kapazität der Antenne 20, also kein real vorhandenes Element, repräsentiert. Diese wird auch als parasitäre Wicklungskapazität der Antenne bezeichnet. Die Darstellung dieser Kapazität dient in Fig. 1 der Illustration, dass die Antenne 20 einen Schwingkreis darstellt, der durch ein Messfeld der Sendeantenne 12, das die Eigenresonanzfrequenz des Schwingkreises aufweist, zu einer Schwingung angeregt werden kann.

Nach einem Senden eines elektromagnetischen Messfeldes im vorgegebenen Frequenzbereich durch die Sendeantenne 12 des Messgerätes 10 kann der Einfluss der Antenne 20 auf das Messfeld aufgrund der elektromagnetischen Einkopplung in einer charakteristischen Leistungskurve gemessen werden. Die Frequenz des Messfeldes wird hierbei in dem vorgegebenen Frequenzbereich automatisch durchgestimmt (gewobbelt).

Fig. 2 zeigt eine schematische Darstellung einer Messanordnung für eine Vielzahl von Antennen 20, die entsprechend dem zu Fig. 1 beschriebenen Verfahren getestet werden. Das Messgerät 10 mit seiner Sendeantenne 12 ist geeignet zu den Antennen 20 angeordnet, um eine Messung durchzuführen. Der Einfluss der bereits gemessenen Antennen und der noch zu messenden Antennen auf das Messfeld der Sendeantenne 12 wird durch geeignete Maßnahmen so abgeschirmt, dass in dem Messgerät 10 nur der Einfluss der zu messenden Antenne 20 wirksam wird. Die Abschirmung 13 kann durch entsprechend angeordnete metallische Platten realisiert sein.

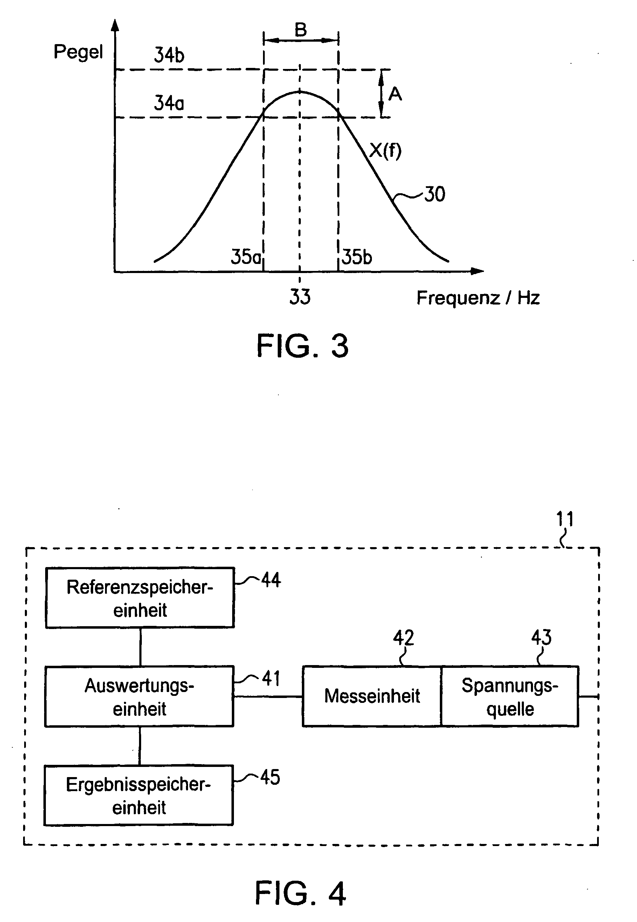

Fig. 3 zeigt eine Messkurve 30 des gemessenen Pegels aufgetragen gegenüber der Frequenz des gesendeten Messfeldes. Die Messkurve 30 stellt die Kurve einer Normantenne mit einer Mittenfrequenz 33 dar, die eine Frequenz des maximalen Pegels ist. Um den maximalen Pegel herum sind eine Untergrenze 34a und eine Obergrenze 34b dargestellt, wobei der gemessene Pegel einer Antenne in diesem Bereich A liegen muss, damit die Antenne als qualitativ gut eingestuft wird. Um die Mittenfrequenz 33 ist ein Bereich B von einer unteren Frequenz 35a bis zu einer oberen Frequenz 35b angedeutet, in dem die Mittenfrequenz der gemessenen Antenne liegen muss, um als qualitativ gut eingestuft zu werden.

Fig. 4 zeigt eine schematische Darstellung der in der Zentraleinheit 11 angeordneten Einheiten. Ein Messgerät umfasst gemäss Fig. 4 neben der nicht dargestellten Sendeantenne eine Spannungsquelle 43 zur Erzeugung einer Wechselspannung vorgegebener Frequenz. Weiterhin dargestellt ist eine Messeinheit 42, die für die zu messende Antenne bei der vorgegebenen Frequenz den Einfluss der Antenne auf das Messfeld, anhand der für ein Senden des Messfeldes notwendigen Leistung in der Spannungsquelle 43, misst.

Eine Auswertungseinheit 41 vergleicht den in der Messeinheit 42 gemessenen Wert mit einem Referenzwert für eine Normantenne. Dieser Referenzwert kann in einer Referenzspeichereinheit 44 abgelegt sein. Das Ergebnis der Auswertung kann zugeordnet zu der gemessenen Antenne in dem Ergebnisspeicher 45 gespeichert werden. Als Ergebnis kann beispielsweise die qualitative Einstufung "gute Antenne", die weiter zu verwenden ist, oder "schlechte Antenne", die auszusortieren ist, gespeichert werden.

Eine Steuerungseinheit, die als Teil der Auswertungseinheit 41 ausgebildet sein kann, steuert das variieren der vorgegebenen Frequenz in der Spannungsquelle 43. Die Auswertungseinheit 41, beispielsweise in Form eines Computers, die Steuereinheit oder die Speichereinheiten 44,45 können auch außerhalb der Zentraleinheit 11 des Messgerätes angeordnet sein.

## Patentansprüche

1. Verfahren zum kontaktlosen Testen einer noch nicht mit einem Chip verbundenen Antenne eines Transponders für ein Identifikationssystem mittels eines Messgeräts, wobei der Transponder in einem vollständig bestückten Zustand einen Chip aufweist, der mit der Antenne verbunden ist, und wobei das Verfahren die folgenden Schritte aufweist:
Senden eines elektromagnetischen Messfeldes mittels einer Sendeantenne des Messgerätes, wobei die Frequenz des Messfeldes beim Senden in einem vorbestimmten Frequenzbereich um die Eigenresonanzfrequenz der Antenne variiert wird;
Empfangen eines elektromagnetischen Messfeldes mittels der Sendeantenne und Messen einer charakteristischen Leistungskurve des elektromagnetischen Einflusses der Antenne des unbestückten Transponders auf das Messfeld;
Vergleichen einer aus der gemessenen Leistungskurve ermittelten Mittenfrequenz mit einem ersten Referenzwert für eine Normantenne.

2. Verfahren nach Anspruch 1, weiterhin umfassend den Schritt:
Vergleichen der Leistung des empfangenen Messfeldes mit einem zweiten Referenzwert, wobei der Einfluss der Antenne auf das Messfeld anhand der Änderung der empfangenen Leistung im Vergleich zu der ausgesendeten Leistung in der Spannungsquelle gemessen wird.

3. Verfahren nach Anspruch 2, wobei der zweite Referenzwert einen Normbereich (A) für einen gemessenen Pegel der Leistung (X(f)) umfasst, in welchem der maximale gemessene Pegel liegen soll.

4. Verfahren nach einem der Ansprüche 1 bis 3, wobei der erste Referenzwert einen Normbereich (B) für eine Frequenz (f) umfasst, in welchem die Frequenz liegen soll, bei welcher der maximale gemessene Pegel gemessen wird.

5. System zum kontaktlosen Testen einer noch nicht mit einem Chip verbundenen Antenne eines Transponders für ein Identifikationssystem, wobei der Transponder in einem vollständig bestückten Zustand einen Chip aufweist, der mit der Antenne verbunden ist, und wobei das System folgendes umfasst:
mindestens einen unbestückten Transponder mit der Antenne (20) und
ein Messgerät (10) mit
einer Spannungsquelle (43) zum Erzeugen einer Wechselspannung vorgegebener Frequenz;
eine Steuerungseinheit zum Variieren der vorgegebenen Frequenz in einem vorbestimmten Frequenzbereich um die Eigenresonanzfrequenz der unbestückten Antenne;
einer Sendeantenne (12) zum Senden eines elektromagnetischen Messfeldes mit der vorgegebenen Frequenz;
einer mit der Sendeantenne (12) verbundenen Messeinheit (42) zum Messen einer charakteristischen Leistungskurve des elektromagnetischen Einflusses der Antenne des unbestückten Transponders auf das Messfeld;
einer Auswertungseinheit (41) zum Vergleichen einer aus der gemessenen Leistungskurve ermittelten Mittenfrequenz mit einem ersten Referenzwert für eine Normantenne.

6. System nach Anspruch 5, wobei die Auswertungseinheit (41) weiterhin so ausgebildet ist, dass sie die Leistung des gesendeten Messfeldes mit einem zweiten Referenzwert vergleicht, wobei der Einfluss der Antenne auf das Messfeld anhand der Änderung der empfangenen Leistung im Vergleich zu der ausgesendeten Leistung in der Spannungsquelle (43) gemessen wird.

7. System nach Anspruch 5 oder 6, wobei das Messgerät (10) weiterhin eine Abschirmung (13) aufweist, die so ausgebildet ist, dass sie einen Einfluss weiterer Antennen auf das Messfeld verhindert.

8. System nach einem der Ansprüche 5 bis 7, weiterhin umfassend eine mit der Auswertungseinheit (41) verbundene Ergebnisspeichereinheit (45) zur Speicherung eines der Antenne des unbestückten Transponders zugeordneten Auswertungsergebnisses.

## Claims

1. A method for contactless testing of an antenna not yet connected to a chip and pertaining to a transponder for an identification system by means of a measuring device, the transponder in a fully fitted state comprising a chip connected to the antenna, and the method comprising the following steps:
transmitting an electromagnetic measuring field by means of a transmitting antenna of the measuring device, the frequency of the measuring field during transmission being varied within a predetermined frequency range around the natural resonant frequency of the antenna;
receiving an electromagnetic measuring field by means of the transmitting antenna and measuring a typical power curve of the electromagnetic influence of the antenna of the non-fitted transponder on the measuring field;
comparing a mean frequency determined from the measured power curve with a first reference value for a standard antenna.

2. The method according to claim 1, further comprising the step of:
comparing the power of the received measuring field with a second reference value, the influence of the antenna on the measuring field being measured on the basis of the change in the received power in comparison with the emitted power in the voltage source.

3. The method according to claim 2, wherein the second reference value comprises a standard range (A) for a measured level of the power (X(f)) in which the maximum measured level is to lie.

4. The method according to any one of claims 1 to 3, wherein the first reference value comprises a standard range (B) for a frequency (f) in which the frequency is to lie at which the maximum measured level is measured.

5. A system for contactless testing of an antenna not yet connected to a chip and pertaining to a transponder for an identification system, the transponder in a fully fitted state comprising a chip connected to the antenna, and the system comprising the following:
at least one non-fitted transponder with the antenna (20) and
a measuring device (10) comprising
a voltage source (43) for generating an a.c. voltage of a predetermined frequency;
a control unit for varying the predetermined frequency within a predetermined frequency range around the natural resonant frequency of the non-fitted antenna;
a transmitting antenna (12) for transmitting an electromagnetic measuring field with the predetermined frequency;
a measuring unit (42) connected to the transmitting antenna (12) for measuring a typical power curve of the electromagnetic influence of the antenna of the non-fitted transponder on the measuring field;
an evaluation unit (41) for comparing a mean frequency determined from the measured power curve with a first reference value for a standard antenna.

6. The system according to claim 5, wherein the evaluation unit (41) is further configured such that it compares the power of the transmitted measuring field with a second reference value, the influence of the antenna on the measuring field being measured on the basis of the change in the received power in comparison with the emitted power in the voltage source (43).

7. The system according to claim 5 or 6, wherein the measuring device (10) further comprises a screen (13) configured such that it prevents any influence of further antennas on the measuring field.

8. The system according to any one of claims 5 to 7, further comprising a result storage means (45) connected to the evaluation unit (41) for storing an evaluation result assigned to the antenna of the non-fitted transponder.

## Revendications

1. Procédé pour tester sans contact une antenne, qui n'est pas encore reliée à une puce, d'un transpondeur pour un système d'identification, au moyen d'un appareil de mesure, où le transpondeur présente dans un état équipé une puce qui est reliée avec l'antenne et dans lequel le procédé comprend les étapes suivantes :
l'envoi d'un champ électromagnétique de mesure au moyen d'une antenne émettrice, où la fréquence du champ de mesure lors de l'envoi est faite variée dans une plage de fréquence prédéterminée autour de la fréquence de résonance propre de l'antenne ;
la réception d'un champ électromagnétique de mesure au moyen de l'antenne émettrice et la mesure d'une courbe caractéristique de puissance de l'influence électromagnétique de l'antenne du transpondeur dans un état non-équipé sur le champ de mesure ;
la comparaison d'une fréquence moyenne, déterminée au moyen des courbes de puissance mesurée, avec une première valeur de référence pour une antenne standard.

2. Procédé selon la revendication 1, qui en outre comprend l'étape de :
comparer la puissance du champs de mesure reçu avec une deuxième valeur de référence, où l'influence de l'antenne sur le champ de mesure est mesurée sur la base de la variation de la puissance reçue en comparaison avec la puissance envoyée au niveau de la source de tension.

3. Procédé selon la revendication 2, dans lequel la deuxième valeur de référence comprend une plage de norme (A) pour un niveau mesuré de la puissance (X(f)), dans laquelle le niveau maximum doit se situer.

4. Procédé selon l'une des revendications 1 à 3, dans lequel la première valeur de référence comprend une plage de norme (B) pour une fréquence (f), dans laquelle la fréquence doit se situer et avec laquelle le niveau maximal mesuré est mesuré.

5. Système pour tester sans contact une antenne, qui n'est pas encore reliée à une puce, d'un transpondeur pour un système d'identification, où le transpondeur présente dans un état équipé une puce, qui est reliée avec l'antenne et dans lequel le système comprend les éléments suivants :
au moins un transpondeur non équipé avec l'antenne (20) et
un appareil de mesure (10) avec
une source de tension (43) pour produire une tension alternative à une fréquence donnée à l'avance ;
une unité de commande pour varier la fréquence prédéterminée dans une plage de fréquence prédéterminée autour de la fréquence de résonance propre de l'antenne non équipée ;
une antenne émettrice (12) pour envoyer un champ de mesure électromagnétique avec la fréquence donnée à l'avance ;
une unité de mesure (42) reliée avec l'antenne émettrice (12) pour mesurer une courbe de puissance caractéristique de l'influence électromagnétique de l'antenne du transpondeur non équipé sur champ de mesure ;
une unité d'analyse (41) pour comparer une fréquence moyenne obtenue grâce aux courbes de puissances mesurées avec une première valeur de référence pour une antenne standard.

6. Système selon la revendication 5, dans lequel l'unité d'analyse (41) est par ailleurs construite de telle sorte qu'elle compare la puissance du champ de mesure envoyé avec une deuxième valeur de référence, où l'influence de l'antenne sur le champ de mesure est mesurée sur la base du changement de la puissance reçue en comparaison avec la puissance envoyée au niveau de la source de tension (43).

7. Système selon la revendication 5 ou 6, dans lequel l'appareil de mesure (10) présente un écran de blindage (13), qui est construit de telle sorte qu'il empêche toute influence d'autres antennes sur le champ de mesure.

8. Système selon l'une quelconque des revendications 5 à 7, qui comprend par ailleurs une unité de sauvegarde de résultats (45) reliée à l'unité d'évaluation (41) pour sauvegarder un des résultats d'évaluation de l'antenne associée au transpondeur non équipé.
